# EUROPÄISCHE PATENTSCHRIFT

(11) **EP 2 087 596 B1**
(45) Veröffentlichungstag und Bekanntmachung des Hinweises auf die Patenterteilung: **17.02.2010**
(21) Anmeldenummer: 07819284.6
(22) Anmeldetag: 24.10.2007
(51) Int. Cl.: H03M 1/52

(54) **MESSVERSTÄRKUNGSVORRICHTUNG UND -VERFAHREN**
MEASUREMENT AMPLIFICATION DEVICE AND METHOD
DISPOSITIF ET PROCÉDÉ D'AMPLIFICATION DE MESURE

(30) Priorität: 27.10.2006 DE 102006051364
(43) Veröffentlichungstag der Anmeldung: 12.08.2009
(73) Patentinhaber: SARTORIUS AG, 37075 Göttingen (DE)
(72) Erfinder: FELDOTTE, Heinrich, 37079 Göttingen (DE); KLAUER, Alfred, 37083 Göttingen (DE)
(86) Internationale Anmeldenummer: PCT/EP2007/009232
(87) Internationale Veröffentlichungsnummer: WO 2008/049603

(56) Entgegenhaltungen:
- DE-A1- 10 040 373
- US-A- 4 268 820
- US-A- 4 764 752
- US-A- 5 229 772
- US-A- 5 262 780

## Beschreibung

### Gebiet der Erfindung

Die Erfindung bezieht sich auf eine Messverstärkungsvorrichtung zur Erfassung eines monopolaren Eingangssignals und zur Erzeugung eines digitalen Ausgangswertes als Maß für das Eingangssignal, umfassend einen von einem Taktgeber mit einem Polaritätswechseltakt angesteuerten, schaltbaren Wechselrichter, der das Eingangssignal in ein mit dem Polaritätswechseltakt bipolares Zwischensignal umwandelt, und einen A/D-Wandler, der das digitale Ausgangssignal in Abhängigkeit von dem Zwischensignal erzeugt.

Die Erfindung bezieht sich weiter auf ein Messverstärkungsverfahren zur Erfassung eines monopolaren Eingangssignals und zur Erzeugung eines digitalen Ausgangswertes als Maß für das Eingangssignal, bei dem das Eingangssignal mittels eines von einem Taktgeber mit einem Polaritätswechseltakt angesteuerten, schaltbaren Wechselrichters in ein mit dem Polaritätswechseltakt bipolares Zwischensignal umgewandelt wird und das digitale Ausgangssignal mittels eines A/D-Wandlers in Abhängigkeit von dem Zwischensignal erzeugt wird.

### Stand der Technik

Die DE 694 24 931 T1 offenbart eine gattungsgemäße Vorrichtung und ein gattungsgemäßes Verfahren. Derartige Verfahren und Vorrichtungen zur digitalisierenden Erfassung von Messsignalen sind unter dem Begriff der Chopper-Verstärkung bzw. -Wandlung bekannt und sollen weiter unten näher erläutert werden.

Vor Einführung des Chopper-Prinzips wurde ein zu messendes Gleichspannungssignal, das hier allgemein als Eingangssignal bezeichnet wird und dessen konkrete Herkunft für die vorliegende Erfindung unerheblich ist, mittels eines Gleichspannungsverstärkers vorverstärkt und anschließend in einem A/D-Wandler digitalisiert. Zur Digitalisierung eignet sich beispielsweise ein sog. integrierender A/D-Wandler.

Das Prinzip des integrierenden A/D-Wandlers ist in vielfältigen Varianten seit Langem bekannt. Beispielhaft seien hier die DE 21 14 141, die DE 28 20 601 C2 sowie die DE 100 40 373 A1 genannt. Beim integrierenden A/D-Wandler wird das Messsignal an einen Eingang eines als Integrator beschalteten Operationsverstärkers angelegt. Zur Beschaltung als Integrator wird der Ausgang des Operationsverstärkers über einen Kondensator mit seinem Messsignal-Eingang verbunden. Ebenfalls mit dem Messsignal-Eingang des Operationsverstärkers verbunden ist die Zuleitung für ein Gleichspannungs-Referenzsignal. Dieses Referenzsignal wird nur zeitweise mit einem Arbeitspegel zugeschaltet. Während der übrigen Zeit liegt es mit einem betragsmäßig niedrigeren Ruhepegel an oder ist vollständig von dem Eingang des Operationsverstärkers getrennt. Während eines ersten Taktanteils eines Messtaktes, in dem der Arbeitspegel des Referenzsignals nicht anliegt, wird der Kondensator durch das im Operationsverstärker verstärkte Messsignal aufgeladen. Wird nach einer vorgegebenen Zeitspanne der Arbeitspegel des Referenzsignals zugeschaltet, entlädt sich der Kondensator während eines zweiten Taktanteils, wodurch das Integrator-Ausgangssignal abfällt. Der Zeitpunkt eines Null-Durchgangs oder allgemeiner eines Schwellenwert-Durchgangs des Integrator-Ausgangssignal wird mittels eines nachgeschalteten Komparators erfasst, der seinerseits über Steuermittel veranlasst, dass der Arbeitspegel des Referenzsignals wieder vom Integrator-Eingang getrennt wird, so dass ein neuer Messtakt mit der Aufladung des Kondensators beginnen kann. Die Dauer des zweiten Taktanteils, d.h. die Zeitspanne, während derer der Arbeitspegel des Referenzsignals am Integrator anliegt, wird mit geeigneten Zeitmessmitteln, beispielsweise einem getakteten Zähler, gemessen. Die gemessene Zeitdauer, hier als Messintervall bezeichnet, stellt ein Maß für die im ersten Taktanteil erfolgte Aufladung des Kondensators und somit für den Pegel des Messsignals dar. Im Fall der Zeitmessung mittels getakteten Zählers kann der Zählerwert unmittelbar als digitales Maß für das Messsignal benutzt werden.

In der Vergangenheit bereitete eine präzise Vorverstärkung des Gleichspannungs-Eingangssignals Schwierigkeiten wegen damit verbundener Offset-Spannungen und deren Drift. Teilweise Abhilfe wurde durch Einführung des Chopper-Prinzips erreicht, das auch Vorteile im Hinblick auf die Unterdrückung des 1/f-Rauschens zeigt.

Bei Anwendung des Chopper-Prinzips wird das Eingangssignal "zerhackt", d.h. mittels eines Wechselrichters in ein bipolares Zwischensignal umgeformt. Das Zwischensignal ist im Wesentlichen ein bipolares Rechtecksignal, dessen Polarität sich mit einem Polaritätswechseltakt ändert. Der Polaritätswechseltakt wird von einem Taktgeber vorgegeben, der über ein entsprechendes Steuersignal mit dem Wechselrichter gekoppelt oder integraler Bestandteil des Wechselrichters selbst ist. Das bipolare Zwischensignal lässt sich mit bekannten Wechselspannungs-Verstärkern vorverstärken. Das vorverstärkte Wechselspannungs-Zwischensignal kann anschließend durch phasenrichtige Gleichrichtung und nachfolgende Tiefpassfilterung wieder in ein Gleichspannungs-Messsignal zurückverwandelt werden, wobei der Gleichrichter typischerweise von demselben Taktgeber angesteuert wird, um die Synchronisierung des Wechselrichtungs- und des nachfolgenden Gleichrichtungsvorgangs sicherzustellen. Die anschließende Digitalisierung des resultierenden Gleichspannungssignals kann dann wie oben erläutert mittels eines integrierenden A/D-Wandlers erfolgen.

Alternativ zur phasenrichtigen Gleichrichtung und anschließenden Tiefpassfilterung des zuvor wechselgerichteten Signals ist es bekannt, das bipolare Wechselrichter-Ausgangssignal unmittelbar und hochfrequent abzutasten, wobei als Maß für das zu bestimmende Signal die Differenz der Mittelwerte der in jeweils benachbarten Halbperioden des Wechselrichter-Ausgangssignals erfassten Abtastwerte dienen können. Dieses Verfahren hat gegenüber dem zuvor erläuterten Verfahren der phasenrichtigen Gleichrichtung und anschließenden Tiefpassfilterung den Vorteil einer digitalen Eliminierung von Offset und Drift der Wechselspannungs-Vorverstärkung. Nachteilig dabei ist jedoch die Notwendigkeit eines sehr hochfrequenten aber in seiner Auflösung begrenzten Abtasters.

Aus der US 2005/0219105 A1 ist ein Sigma-Delta-ADC bekannt, der ein monopolares Eingangssignal nach Maßgabe eines gesonderten Taktgebers vorsampelt und in diskreten Intervallen an einen als analoger Tiefpassfilter arbeitenden, bipolaren Integrator transferiert. Dabei wird die Polarität des vorgesampelten Signals gemäß einem festen, von dem Taktgeben vorgegebenen Polaritätswechseltakt umgeschaltet, um eventuelle Fehlanpassungen zweier paralleler Vorsampling-Kondensatoren sowie einen möglichen Offset des Messsignals zu kompensieren. Das Integrator-Ausgangssignal wird in einem nachgeschalteten Komparator, der als 1-Bit-ADC arbeitet, in eine sehr hochfrequente, digitale Pulsfolge gewandelt, die einem als 1-Bit-DAC arbeitenden Referenzsignal-Schalter zugeführt wird. Der Referenzsignal-Schalter ändert die Polarität des ebenfalls an den Integrator angelegten Referenzsignals gemäß dem HIGH- bzw. LOW-Level des 1-Bit-Signals, um die für die Sigma-Delta-Wandlung charakteristische negative Rückkopplung des digitalen 1-Bitsignals mit dem Eingangssignal des analogen Filters zu erreichen.

Aus der US 5,229,772 ist eine ADC-Schaltung bekannt, bei der ebenfalls ein monopolares Eingangssignal vorgesampelt und zusammen mit einem ebenfalls vorgesampelten Referenzsignal in diskreten Intervallen zu einem Integrator transferiert wird. Im Rahmen des Vorsamplings wird zur Ladungserhöhung jeweils die Polarität des Messsignals und des Referenzsignals umgeschaltet. An den Integrator wird jedoch diskontinuierlich nur eine Polarität des Messsignals angelegt. Der Polaritätswechsel des Messsignals und des Referenzsignals erfolgt auf Basis eines separaten Taktgebers. Das Referenzsignal wir zusätzlich zur Erzeugung von Auf- und Abintegrationsphasen in der weiter oben beschriebenen Art in Abhängigkeit von dem Ausgangssignal eines dem Integrator nachgeschalteten Komparators umgepolt.

Aus der DE 36 33 790 A1 ist eine Vorrichtung mit Spannungs/Frequenz-Wandlung eines Verstimmungssignals einer Messbrücke bekannt, wobei nach dem Prinzip abwechselnder Auf- und Abintegration des Verstimmungssignals und des vergleichens mit einem Schwellenwert in einem Komparator ein Pulszug erzeugt wird, dessen Frequenz repräsentativ für die Brückenverstimmung ist. Bei der bekannten Vorrichtung wird die Speisespannung der Messbrücke willkürlich gemäß einem externen Polaritätswechseltakt umgepolt. Entsprechend wechselt auch das an der Messbrücke anliegende Verstimmungssignal seine Polarität, was in der Regel während einer Aufintegrationsphase geschieht, gegen deren Dauer die Dauer der Abintegrationsphase vernachlässigbar kurz ist. Um hierdurch keinen fehlverschobenen Puls in dem Pulszug zu erhalten, wird ein Ladungsbalance-Zyklus in Gang gesetzt, der eine Verzögerung des auszugebenden Pulses, der auch die nächste Abintegrationsphase einleitet, bewirkt.

### Aufgabenstellung

Es ist die Aufgabe der vorliegenden Erfindung, gattungsgemäße Messverstärker-Vorrichtungen und -Verfahren derart weiterzubilden, dass eine gute Offset- und Driftreduktion von Vorverstärkern ohne Einbringung zusätzlicher, hochfrequenter aber auflösungsbegrenzter Elemente ermöglicht wird.

### Darstellung der Erfindung

Diese Aufgabe wird mit den Merkmalen der Ansprüche 1 und 8 gelöst.

Aus der US-A-4,764,752 ist eine Vorrichtung zur Erfassung eines monopolaren Eingangssignals und zur Erzeugung eines digitalen Ausgangswertes als Maß für das Eingangssignal nach den Merkmale des Oberbegriffs der Ansprüche 1 und 8 bekannt.

Digitalisierung des gegebenenfalls vorverstärkten Zwischensignals durch jeweilige Anpassung des Referenzsignals an die Polarität des Zwischensignals, welche durch den zustand des Wechselrichters bestimmt wird. Während zweier aufeinander folgender Integrationsphasen wird der Kondensator des Integrators in umgekehrter Richtung geladen und nachfolgend wieder entladen. Wie aus dem Stand der Technik bekannt, wird dabei als Messintervall die Entladezeit, d.h. diejenige Zeit, während derer der Arbeitspegel des Referenzsignals anliegt, als Maß für den Pegel des Zwischensignals und somit für das Eingangssignal gemessen.

Ein wesentlicher Vorteil der vorliegenden Erfindung ist der resultierende Verzicht auf die im Stand der Technik erforderliche Gleichrichtung und Tiefpassfilterung des analogen Zwischensignals, d.h. im Wesentlichen des Wechselrichter-Ausgangssignals. Hierdurch werden Bauteile und mit diesen verbundene Fehlerquellen eingespart. Andererseits erübrigt sich auch eine "Gleichrichtung" im digitalen Bereich, d.h. Mittelwert- und Differenzbildung im überabgetasteten, bipolar digitalisierten Zwischensignal, die zu den oben bereits erläuterten Nachteilen führt. Vielmehr fällt die Gleichrichtung als "natürliches" Ergebnis der Digitalisierung mit bipolarem Referenzsignal ab.

Besonders bevorzugte Ausführungsformen der vorliegenden Erfindung sind in den abhängigen Ansprüchen definiert.

Günstigerweise ist die Abhängigkeit des Zwischensignals und des Referenzsignals von dem Komparator-Ausgangssignal so konkretisiert, dass der Komparator zur Ermittlung jedes Zeitpunktes einer Querung des Schwellenwertes durch das Integrator-Ausgangssignal, insbesondere des Null-Durchgangs, eingerichtet ist und zur Rückkopplung des Komparator-Ausgangssignals Steuermittel vorgesehen sind, die in Abhängigkeit von dem ermittelten Querungszeitpunkt den schaltbaren Wechselrichter zu einem Polaritätswechsel des Zwischensignals und die schaltbare Referenzspannungsquelle zum Trennen des Arbeitspegels des Referenzsignals von dem Integrator ansteuern. Mit anderen Worten ist vorzugsweise vorgesehen, dass beim Vergleichen des Integrator-Ausgangssignals mit einem Schwellenwert, insbesondere dem Null-Wert, der Zeitpunkt von dessen Querung durch das Integrator-Ausgangssignal erfasst wird und der Polaritätswechsel des Zwischensignals sowie das Trennen des Arbeitspegels des Referenzsignals vom Integrator in Abhängigkeit von dem erfassten Zeitpunkt erfolgt. Typischweise ist die Steuerung so eingerichtet, dass Schwellwert-Querung bzw. Null-Durchgang des Integrator-Ausgangssignals, Polaritätswechsel des Zwischensignals und Trennen des Arbeitspegels des Referenzsignals vom Integrator-Eingang im Wesentlichen gleichzeitig bzw. taktsynchron mit dem Takt eines zur Zeitmessung verwendeten, getakteten Zählers erfolgen. Es können jedoch gezielte Abweichungen von der taktsynchronen Gleichzeitigkeit eingestellt werden. Vergleichbare Abweichungen zur Verbesserung des Konvergenzverhaltens einer A/D-Wandlervorrichtung sind aus der bereits zitierten DE 100 40 373 A1 bekannt. Die dort offenbarten Prinzipien lassen sich auf einfache Weise auch auf die vorliegende Erfindung anwenden.

Bei einer besonders vorteilhaften Weiterbildung dieser Ausführungsform der Erfindung ist vorgesehen, dass die Steuermittel weiter eingerichtet sind, die schaltbare Referenzspannungsquelle jeweils nach einem vorbestimmten zeitintervall nach dem Trennen des Arbeitspegels des Referenzsignals von dem Integrator zum erneuten Anlegen des Arbeitspegels des Referenzsignals an den Integrator anzusteuern. Bezogen auf das erfindungsgemäße Verfahren bedeutet dies, dass der Arbeitspegel des Referenzsignals jeweils nach einem vorbestimmten Zeitintervall nach dem Trennen des Arbeitspegels des Referenzsignals von dem Integrator erneut an den Integrator angelegt wird. Mit anderen Worten heißt das, dass die Zeitdauer, in der das Referenzsignal nicht bzw. der Ruhepegel des Referenzsignals am Integrator anliegt, somit die Zeitdauer, während derer der Kondensator des Integrators aufgeladen wird, im Wesentlichen fest eingestellt ist. Dem Integrator wird also eine vordefinierte Aufladezeit gewährt. Variabel und von der Menge der aufintegrierten Ladung abhängig ist hingegen die Entladezeit des Kondensators, d.h. die zeit, während derer der Arbeitspegel des Referenzsignals anliegt. Diese Phase, das Messintervall, wird durch das Komparator-Ausgangssignal beendet und ihre Dauer wird als Maß für den Pegel des Zwischensignals bestimmt. Man beachte, dass bei dieser Ausführungsform der Erfindung zur Bestimmung des Messintervalls in der Praxis auch die Dauer des gesamten Messtaktes, d.h. der Dauer einer Auf- und einer Abintegrationsphase, was bei einer bevorzugten Ausführungsform der Erfindung gleich der Dauer zwischen zwei Polaritätswechseln der Speisespannung ist, als Maß für das Zwischensignal bzw. daraus folgend für das Eingangssignal benutzt werden kann, da zu dem variablen Taktteil, d.h. dem Messintervall oder der Entladephase des Kondensators nur eine konstante Zeitdauer, nämlich die Dauer der Aufladephase des Kondensators hinzuaddiert wird.

Alternativ zu der zuvor geschilderten Variante mit variablem Messtakt kann bei einer anderen, ebenfalls günstigen Ausführungsform der Erfindung der Messtakt konstant gehalten werden. Hierzu ist vorgesehen, dass die Steuermittel weiter eingerichtet sind, die schaltbare Referenzspannungsquelle jeweils nach einem festen Zeitintervall nach einem vorangegangenen Anlegen des Arbeitspegels des Referenzsignals an den Integrator zum erneuten Anlegen des Arbeitspegels des Referenzsignals an den Integrator anzusteuern. Im Hinblick auf das erfindungsgemäße Verfahren bedeutet dies, dass der Arbeitspegel des Referenzsignals jeweils nach einem festen Zeitintervall nach einem vorangegangenen Anlegen des Referenzsignals an den Integrator erneut an den Integrator angelegt wird. Mit anderen Worten bleibt die Zeitspanne zwischen zwei aufeinander folgenden Schaltvorgängen zum Anlegen des Arbeitspegels des Referenzsignals an den Integrator konstant. Variabel ist dagegen die Zeitspanne während derer der Arbeitspegel des Referenzsignals an den Integrator angelegt bleibt bzw. die Zeit, in der das Referenzsignal nicht bzw. der Ruhepegel des Referenzsignals an den Integrator angelegt ist. Variabel sind somit die Proportionen der Auflade- und Entladephase innerhalb eines festen Messtaktes. Man beachte, dass aufgrund der einfachen Abhängigkeit der Dauern von Entladephase und Aufladephase voneinander in der Praxis jede dieser Phasen zur Bestimmung des Messintervalls gemessen werden und als Basis für ein Maß für den Pegel des Zwischensignals bzw. daraus folgend für das das Eingangssignal dienen kann.

Wie bereits erwähnt, stellen Offset und Drift eines gegebenenfalls eingesetzten Wechselspannungs-Vorverstärkers ein ernsthaftes Problem für die Genauigkeit der Messung des Eingangssignals dar. Ein Offset führt dazu, dass während zweier aufeinander folgender Messtakte mit verschiedener Polarität des Zwischensignals unterschiedliche Signalpegel am Integrator anliegen. Die Drift führt hingegen dazu, dass sich ein solcher Offset nicht durch eine einmalige Einstellung eliminieren lässt, weil er sich mit der Zeit verändert, z.B. aufgrund von Temperatur oder Feuchte. Diese Veränderung erfolgt jedoch in der Regel sehr langsam im Vergleich zu der Dauer der Messtakte. Zur Eliminierung des zeitveränderlichen Offsets sind daher bei einer bevorzugten Weiterbildung der Erfindung Additionsmittel zur Aufsummierung einer geraden Anzahl von Messintervalldauern und Ausgabemittel zur Ausgabe eines Ausgabewertes auf Basis des aufsummierten Wertes als Maß für das Eingangssignal vorgesehen. Im Hinblick auf das erfindungsgemäße Verfahren bedeutet dies, dass eine gerade Anzahl aufeinander folgender Messintervalldauern aufsummiert werden und auf Basis des aufsummierten Wertes ein Maß für das Eingangssignal ausgegeben wird. Hierdurch wird der jeweils aktuelle Offset vollständig eliminiert.

Gleichzeitig wird durch die Aufsummierung der Messintervalldauern die Auflösung der Gesamtmessung verbessert. Eine unabhängige Messung einer Intervalldauer mittels eines getakteten Zählers ist mit einem Fehler von einem Zählertakt belegt. Es ist daher unmittelbar einleuchtend, dass eine kontinuierliche Messung, die eine (geradzahlige) Anzahl von Intervalldauern umfasst und ebenfalls nur mit einem Fehler von einem Zählertakt belegt ist, einen geringeren Relativfehler, d.h. eine bessere Auflösung aufweist. Die Auflösungsverbesserung kommt im vorliegenden Fall jedoch auch zustande, wenn eine (geradzahlige) Anzahl aufeinander folgender, separat gemessener Messintervalldauern aufaddiert werden. Dies liegt daran, dass aufgrund der taktsynchronen Steuerung des Referenzsignals die Dauern der Kondensator-Aufladeintervalle nicht unabhängig sind von den Dauern der Messintervalle, zwischen denen sie eingebettet sind, d.h. die Regeln der sog. Gauß'schen Fehlerfortpflanzung nicht anwendbar sind. Der auflösungsverbessernde Effekt der Aufsummierung einer geradzahligen Anzahl von Messintervalldauern ergibt sich daher bei jeder der oben beschriebenen Varianten.

Vorzugsweise ist vorgesehen, dass die Additionsmittel eingerichtet sind, einer aktuellen Bestimmung des aufsummierten Wertes die einer vorangegangenen Bestimmung zugrunde liegende Folge von Messintervalldauern ohne eine vorgegebene Anzahl von Dauern ältester Messintervalle und mit zusätzlich derselben Anzahl Dauern jüngster, bei der vorangegangenen Bestimmung nicht berücksichtigter Messintervalle zugrunde zu legen. Bezogen auf das erfindungsgemäße Verfahren bedeutet dies, dass einer aktuellen Bestimmung des aufsummierten Wertes die einer vorangegangenen Bestimmung zugrunde liegende Folge von Messintervalldauern ohne eine vorgegebene Anzahl von Dauern ältester Messintervalle und mit zusätzlich derselben Anzahl von Dauern jüngster, bei der vorangegangenen Bestimmung nicht berücksichtigter Messintervalle zugrunde gelegt werden. Mit anderen Worten wird die Folge von Messintervallen, deren Dauern jeweils für die Ermittlung eines offsetfreien Maßes für das Eingangssignal aufsummiert werden, nach Art eines "gleitenden Fensters" bestimmt. Werden beispielsweise die zu den Zeiten t1, t2, t3 und t4 (mit t1 < t2 < t3 < t4) gemessenen Messintervalldauern zur Bestimmung des aufsummierten Wertes addiert, können bei einer nachfolgenden Bestimmung die zu den Zeiten t2, t3, t4 und t5 (mit t2 < t3 < t4 < t5) gemessenen Intervalldauern addiert werden. Auf diese Weise lässt sich nach jeder Bestimmung einer Messintervalldauer ein aktualisiertes Maß für das Eingangssignal ausgeben, wobei jeder aktuelle Ausgabewert von der aus der Aufsummierung resultierenden Offsetfreiheit und Auflösungshöhe profitiert. In diesem Beispiel wird das "gleitende Fenster" jeweils um ein Messintervall verschoben. Selbstverständlich sind jedoch auch andere Schrittgrößen der Verschiebung möglich.

Schließlich sei noch auf die Gefahr hingewiesen, dass durch die erfindungsgemäße Umpolung von Zwischen- und Referenzsignal eine zusätzliche Fehlerquelle erzeugt werden kann. Der hierdurch eingeführte Fehler wächst dabei mit der Häufigkeit der Umpolung. Bei einer Abwandlung der Erfindung kann daher vorgesehen sein, dass der Polaritätswechsel des Zwischensignals und somit auch der Referenzspannung nicht in jedem Messtakt, sondern nach nur in jedem n-ten Messtakt, d.h. nach jedem n-ten Messintervall angesteuert wird, wobei n vorzugsweise zwischen 2 und 100, insbesondere zwischen 2 und 10 liegt. Die konkrete Wahl von n ist in Abwägung des durch die Umschaltungshäufigkeit eingeführten Fehlers gegen die gesteigerte Reaktionsträgheit bei Wahl großer n zu treffen. Für die Eliminierung des Offsets durch Aufsummierung ist nämlich bei dieser Ausführungsform die Aufsummierung eines geradzahligen Vielfachen von n Messintervalldauern erforderlich. Die Wahl der Schrittgröße im Fall der Anwendung eines gleitenden Fensters ist bei dieser Variante hingegen nicht beschränkt.

### Kurzbeschreibung der Zeichnungen

Weitere Merkmale und Vorteile ergeben sich aus der nachfolgenden speziellen Beschreibung und den Zeichnungen. Es zeigen:
- Figur 1:: ein schematisches Ersatzschaltbild einer Ausführungsform der vorliegenden Erfindung,
- Figur 2:: eine alternative Ausführungsform des Wechselrichters,
- Figur 3:: ein schematisches Timing-Diagramm einer ersten Ausführungsform der vorliegenden Erfindung,
- Figur 4:: eine schematisches Timing-Diagramm einer zweiten Ausführungsform der vorliegenden Erfindung.

### Beschreibung bevorzugter Ausführungsformen

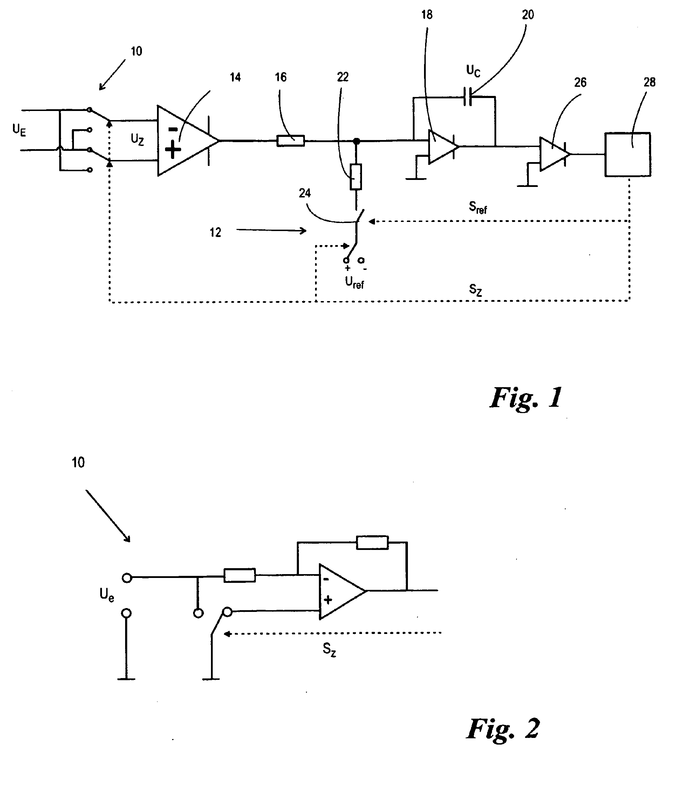

Figur 1 zeigt schematisch ein Ersatzschaltbild einer Vorrichtung gemäß der vorliegenden Erfindung. Im linken Bereich von Figur 1 ist eine Wechselrichter-Schaltung 10 mit zwei simultan schaltbaren Schaltern 12a und 12b dargestellt, die ein am Eingang des Wechselrichters 10 anliegendes Eingangssignal U_{E}, d.h. eine zu messende monopolare Spannung in ein im Wesentlichen rechteckförmiges, bipolares Zwischensignal U_{Z} umwandelt. Die Umwandlung erfolgt im Takt des Schaltung des Wechselrichters 10, die ihrerseits von einem Steuersignal S_{Z} vorgegeben wird, das an einem Steuereingang des Wechselrichters 10 anliegt. Dieser Takt wird hier als Polaritätswechseltakt bezeichnet.

Figur 2 zeigt eine alternative Ausführungsform des Wechselrichters 10 die mit nur einem anzusteuernden Schalter auskommt, dafür jedoch einen zusätzlichen Operationsverstärker benötigt.

Die konkrete Ausgestaltung des Wechselrichters 10 ist für die vorliegende Erfindung nicht relevant und kann vom Fachmann in Ansehung der speziellen Anforderungen der konkreten Anwendung gewählt werden. Auch auf die Herkunft des Eingangssignals U_{E} kommt es für die vorliegende Erfindung nicht an.

Das aus der Wechselrichtung resultierende Zwischensignal U_{Z} wird bei der Ausführungsform gemäß Figur 1 von einem wechselspannungs-Vorverstärker 14 geeignet vorverstärkt. Der Vorverstärker 14 ist typischerweise Offset- und Driftbehaftet, so dass an dieser Stelle typischerweise zu korrigierende Fehler in die Messung einfließen.

Die Ausgangsspannung des Vorverstärkers 14 wird über einen Widerstand 16 in einen entsprechenden Strom umgewandelt, der an einen ersten Eingang eines als Integrator beschalteten Operationsverstärkers 18 angelegt wird. Der zweite Eingang des Operationsverstärkers 18 ist im vorliegenden Fall gegen Masse geschaltet, wobei jedoch auch jedes andere Konstantpotential grundsätzlich angelegt werden könnte. Die Beschaltung des Operationsverstärkers 18 als Integrator ist realisiert durch die Rückkopplung seines Ausgangssignals zu seinem ersten Eingang über den Integrationskondensator 20, über dem die Kondensator-Spannung U_{c} anliegt.

Ebenfalls an den ersten Eingang des Operationsverstärkers 18 angelegt ist eine über den Widerstand 22 in einem Strom umgewandelte Referenzspannung U_{ref}. Die Referenzspannung U_{ref} entspringt einer schaltbaren Referenzspannungsquelle 12, die in geeigneter Weise mit dem Wechselrichter 12 synchronisiert ist. Bei der in Figur 1 dargestellten Ausführungsform ist dies besonders vorteilhaft dadurch realisiert, dass als Referenzspannungsquelle 12 eine schaltbare Gleichspannungsquelle zusammen mit einem zusätzlichen Schalter 24 Verwendung findet, wobei die schaltbare Gleichspannungsquelle von demselben Steuersignal S_{Z} angesteuert wird wie der Wechselrichter 10. Auf diese Weise ist sichergestellt, dass die Referenzspannung U_{ref} im Polaritätswechseltakt, d.h. stets gleichzeitig mit dem Zwischensignal U_{Z} einen Polaritätswechsel durchläuft, wobei jedoch durch den zusätzlichen Schalter 24 eine zusätzliche Taktung aufgeprägt werden kann. Der Schalter 24 wird über ein eigenes Steuersignal S_{ref} gesteuert. Man beachte, dass bei der gezeigten Ausführungsform die Referenzspannung U_{ref} entweder an den Eingang des Operationsverstärkers angelegt ist oder von diesem getrennt ist. Bei anderen denkbaren Ausführungsformen kann anstelle der Trennung ein Anlegen eines betragsmäßig niedrigeren Ruhepegels vorgesehen sein.

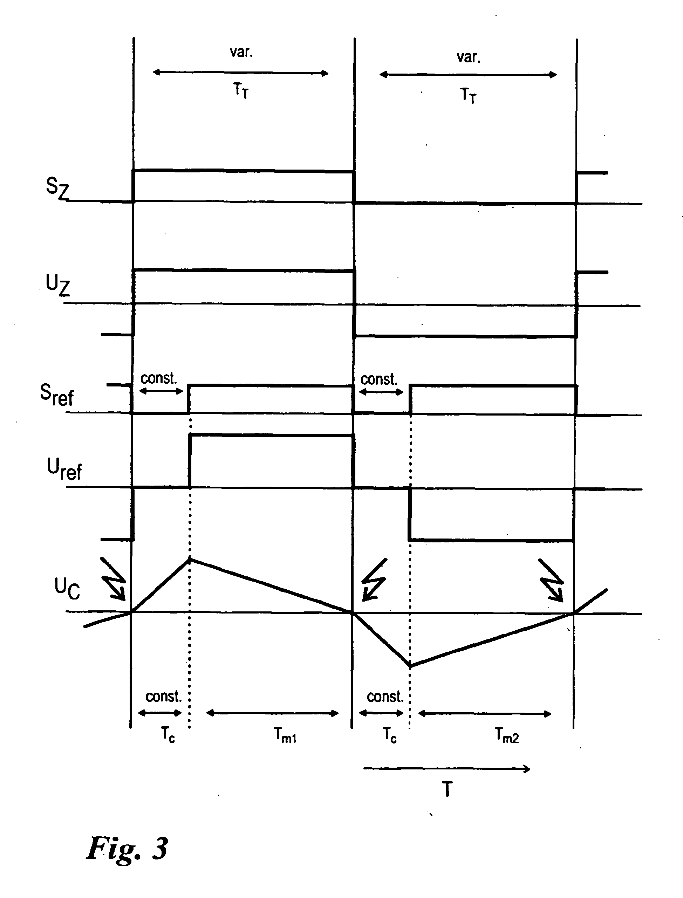

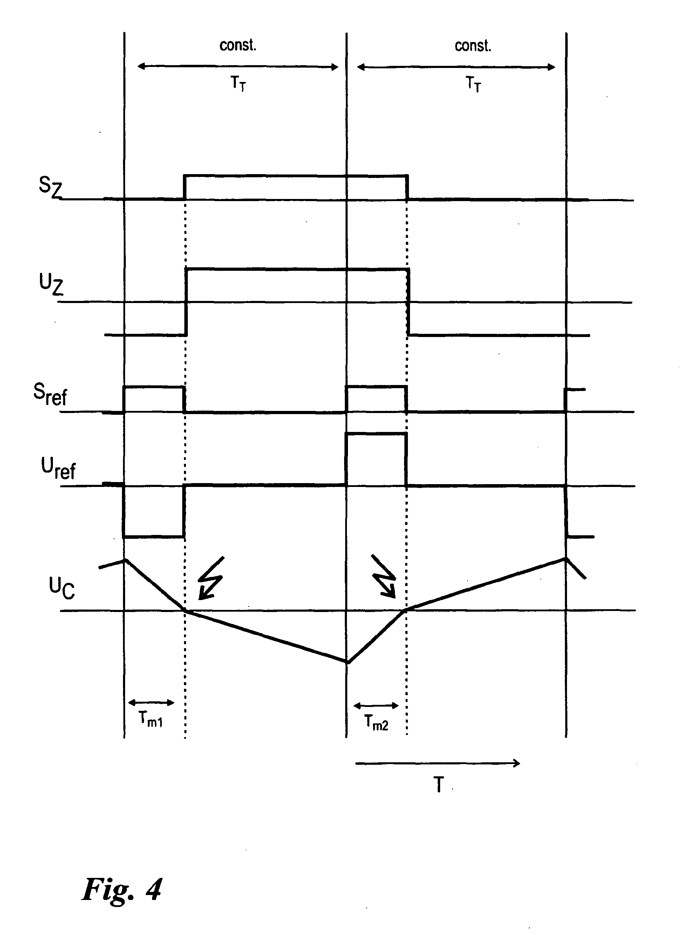

Dem Integrator aus Operationsverstärker 18 und Kondensator 20 nachgeschaltet ist ein Komparator 26, der in der gezeigten Ausführungsform als gegen Masse geschalteter Differenzverstärker ausgebildet ist. Bei anderen Ausführungsformen kann der Komparator auch gegen ein von Masse verschiedenes Potential geschaltet sein. Mit dem Komparator lassen sich die Zeitpunkte des Null-Durchgangs der Integrator-Ausgangsspannung erfassen. Dem Komparator 26 nachgeschaltete Steuermittel 28 verarbeiten das Komparator-Ausgangssignal zur Erzeugung der Steuersignale S_{Z} und S_{ref} zur Ansteuerung des Wechselrichters 10 bzw. der Referenzspannungsquelle 12. Die Steuermittel 28 sind in Figur 1 als reiner Funktionsblock dargestellt und können auf unterschiedliche Weisen in reiner Hardware oder als eine Kombination aus Hardware und Software realisiert sein. Ihre Funktionsweise wird nachfolgend für zwei besonders bevorzugte Ausführungsformen der Erfindung anhand der Timing-Diagramme der Figuren 3 und 4 erläutert.

Figur 3 zeigt ein Timing-Diagramm gemäß einer ersten Ausführungsform der vorliegenden Erfindung. Die Darstellung ist lediglich zur Veranschaulichung der relativen, zeitlichen Verhältnisse der einzelnen Signale zueinander gedacht, wobei die Darstellung in willkürlichen Einheiten erfolgt. Wie bereits erläutert, folgt das bipolare Zwischensignal U_{Z} dem Steuersignal S_{Z}, welches bei der dargestellten Ausführungsform ein monopolares Signal ist, aber selbstverständlich auch beispielsweise bipolar und/oder als Pulssignal ausgeführt sein könnte. Wesentlich ist, dass die Polaritätswechsel des Zwischensignals U_{Z} sowie der Referenzspannung U_{ref} in Abhängigkeit von dem Steuersignal S_{S} erfolgen. Zur Vereinfachung der Darstellung ist das Ausgangssignal des invertierenden Vorverstärkers 14, welches gegenüber dem Zwischensignal U_{Z} einen eventuell zeitlich veränderlichen Offset aufweisen kann, in Figur 3 nicht gezeigt. Man beachte, dass die invertierende Natur des Vorverstärkers 14 nicht erfindungsrelevant, sondern von der Konstellation der an verschiednen Stellen der Schaltung angelegten Potentiale abhängig ist. Es kommt lediglich darauf an, dass das vorverstärkte Zwischerisignals eine andere Polarität als das Referenzsignal aufweist.

Wie erläutert, zeigt die Referenzspannung U_{ref} im Wesentlichen dieselben Polaritätswechsel wie das Zwischensignal U_{Z}. Hinzu kommt die Taktung durch das Steuersignal S_{ref}. Bei der Ausführungsform gemäß Figur 3 wird die Referenzspannung U_{ref} zu Beginn jedes Messtaktes vom Eingang des Integrators 18, 20 getrennt. Während dieser Zeit liegt am Eingang des Operationsverstärkers 18 nur das invertierend vorverstärkte Zwischensignal U_{Z} an. Während dieses ersten Taktanteils T_{c} des Messtaktes T_{T} lädt sich der Kondensator 20 auf, was zu einem (betragsmäßigen) Anstieg der Kondensatorspannung U_{c} führt. Nach der vorbestimmten Zeit T_{c}, die bei der Ausführungsform von Figur 3 konstant ist, wird durch Umlegen des Schalters 24 in Abhängigkeit von dem Steuersignal S_{ref} zusätzlich die Referenzspannung U_{ref} an den Eingang des Integrators 18, 20 angelegt. Aufgrund ihrer zum Zwischensignal U_{Z} umgekehrten Polarität entlädt sich während des nun folgenden Taktanteils Tₘ der Kondensator 20 und zwar solange, bis die Kondensatorspannung U_{c} einen Null-Durchgang erfährt, der vom Komparator 26 registriert wird. Diese Zeitpunkte sind in Figur 3 durch Blitzpfeile gekennzeichnet. Der Zeitpunkt des Null-Durchgangs wird von den Steuermitteln 28 in eine taktsynchrone Änderung der Steuersignale S_{Z} und S_{ref} übersetzt, so dass sich zum einen die Polarität des Zwischensignals U_{Z} und der Referenzspannung U_{ref} ändert und zusätzlich die Referenzspannung U_{ref} vom Eingang des Integrators 18, 20 getrennt wird. Der nachfolgende Messtakt läuft in derselben Weise wie oben beschrieben, jedoch bei umgekehrten Polaritäten ab.

Der Pegel des Zwischensignals U_{Z} wird durch diejenige Zeitdauer repräsentiert, die erforderlich ist, um den Kondensator 20 nach einer konstanten Aufladezeit T_{c} wieder zu entladen, d.h. bis zum Null-Durchgang von U_{c}. Diese Zeitdauer ist das Messintervall Tₘ. Da die Aufladezeit T_{c}, wie erwähnt, konstant ist, kann sowohl die Dauer des Messintervalls Tₘ als auch die Dauer des gesamten Messtaktes T_{T} = T_{c} + Tₘ als Maß für den Pegel des Zwischensignals U_{Z} bestimmt,werden. Die Erfassung der Dauer von Tₘ bzw. T_{T} = T_{c} + Tₘ erfolgt vorzugsweise über einen hochfrequenten Zähler, der mit Beginn von T_{c} oder Tₘ, vorzugsweise in Abhängigkeit von S_{ref} und/oder S_{Z}, angestoßen wird. Die Erfassung der verschiedenen Intervalldauern kann mit einem einzigen Zähler erfolgen.

Wie erwähnt, kann es sein, dass durch den Vorverstärker 14 ein Offset in das Zwischensignal U_{Z} eingebracht wird. Dies würde bedeuten, dass die Intervalle unterschiedlicher Polarität unterschiedliche Pegel des Zwischensignals U_{Z} liefern würden. Dies wiederum hätte zur Folge, dass zwei aufeinander folgende Messtakte unterschiedlicher Polarität unterschiedliche Dauern hätten, wobei die Dauer eines Messtaktes um denselben Betrag zu lang wäre, wie die Dauer des anderen Messtaktes zu kurz wäre. Durch Addition zweier oder allgemeiner einer geradzahligen Mehrzahl von Messintervall- oder Messtaktdauern kann dieser Fehler daher korrigiert werden, sodass der aufsummierte Wert ein genaues Maß für das Eingangssignal U_{E} ist. Man beachte, dass diese Korrektur unabhängig von einer zeitlichen Drift des Offsets ist, sofern die Drift langsam im Vergleich zu der aufaddierten Gesamtdauer ist. Aufgrund der Konstanz der Aufladeperiode T_{c} können sowohl aufeinander folgende Messintervalle Tₘ₁ und Tₘ₂ auch die Dauern zweier aufeinander folgender vollständiger Messtakte (T_{c} + Tₘ₁) + (T_{c} + Tₘ₂) dienen. Hierdurch kann, wie weiter oben bereits erläutert, die Auflösung der Digitalisierung verbessert werden. Eine rasche Aktualisierung des ausgegebenen Maßes für das Eingangssignal U_{E} kann durch Auswahl der aufzusummierenden Messintervalldauern nach der weiter oben erläuterten Methode des "gleitenden Fensters" erreicht werden.

Figur 4 zeigt ein schematisches Timing-Diagramm einer zweiten Ausführungsform der vorliegenden Erfindung, für dessen Darstellung ebenfalls das oben zur Darstellung von Figur 3 gesagte gilt. Im Unterschied zu der Ausführungsform gemäß Figur 3 ist in Figur 4 die Gesamtdauer jedes Messtaktes T_{T} konstant. Variabel sind lediglich die relativen Anteile der Aufladungsphase und des eigentlichen Messintervalls Tₘ, d.h. auch hier derjenigen Zeit, die benötigt wird, um den aufgeladenen Kondensator durch zusätzliches Anlegen der Referenzspannung U_{ref} zu entladen.

Im Übrigen lässt sich das Timing-Diagramm der Figur 4 analog zu den Erläuterungen zu Figur 3 interpretieren. Man beachte, dass die unterschiedlichen Steigungen der einzelnen Abschnitte von U_{c} durch die relativen Pegel des (gegebenenfalls vorverstärkten) Zwischensignals U_{Z} und der Referenzspannung U_{ref} bedingt sind.

Natürlich stellen die in den Figuren gezeigten und in der speziellen Beschreibung diskutierten Ausführungsformen nur illustrative Ausführungsbeispiele der vorliegenden Erfindung dar. Dem Fachmann ist im Lichte der hiesigen Offenbarung ein breites Spektrum an variationsmöglichkeiten anhand gegeben. Insbesondere kann von der strengen Synchronisierung der einzelnen, schaltbaren Signale geringfügig abgewichen werden, beispielsweise um bei starken Pegeländerungen des Eingangssignals U_{E} eine rasche Konvergenz des digitalisierten Signals zu erreichen.

## Patentansprüche

1. Messverstärkungsvorrichtung zur Erfassung eines monopolaren Eingangssignals (U_{E}) und zur Erzeugung eines digitalen Ausgangswertes als Maß für das Eingangssignal (U_{E}), umfassend eine von einem Taktgeber mit einem Polaritätswechseltakt angesteuerten, schaltbaren Wechselrichter (10), der das Eingangssignal (U_{E}) in ein mit dem Polaritätswechsoltakt bipolares Zwischensignal (U_{Z}) umwandelt, und einen A/D-Wandler, der den digitalen Ausgangswert in Abhängigkeit von dem Zwischensignal erzeugt,
wobei der A/D-Wandler umfasst:
einen Integrator (18, 20), der das bei Betrieb dauerhaft an ihn angelegte Zwischensignal (U_{Z}) und einen zeitweise an ihn angelegten Arbeitspegel eines bipolaren Referenzsignals (U_{ref}) aus einer von dem Taktgeber angesteuerten, schaltbaren Referenzspannungsquelle (12, 24) repetitiv integriert,
einen dem Integrator (18, 20) nachgeschalteten Komparator (26), der ein Integrator-Ausgangssignal mit einem Schwellenwert vergleicht, wobei ein von dem Vergleichsergebnis abhängiges Komparator-Ausgongssignal als Steuersignal (S_{Z}) zu dem Wechselrichter und der Referenzspannungsquelle rückgekoppelt ist, und
Zeitmessmittel, die die Dauer von Messintervallen (Tₘ), während derer der Arbeitspegel des Referenzsignals (U_{ref}) an den Integrator (18, 20) angelegt ist, als Basis eines Maßes für das Eingangssignal erfassen,
**dadurch gekennzeichnet,**
**dass** die schaltbare Referenzspannungsquelle (12, 24) mit dem Wechselrichter (10) mittels des zur Vorgabe des Polaritätswechseltaktes rückgekoppelten Steuersignals (S_{Z}) synchronisiert ist, sodass das Referenzsignal (U_{ref}) mit dem Polaritätswechseltakt bipolar ist.

2. Vorrichtung nach Anspruch 1,
**dadurch gekennzeichnete**
**dass** der Komparator (26) zur Ermittlung jedes Zeitpunktes einer Qucrung des Schwellenwertes durch das Integrator-Ausgangssignal eingerichtet ist und zur Rückkopplung des Komparator-Ausgangssignals Steuermittel (28) vorgesehen sind, die in Abhängigkeit von dem ermittelten Querungszeitpunkt den schaltbaren Wechselrichter (10) zu einem Polaritätswechsel des zwischensignals (U_{Z}) und die schaltbare Referenzspannungsquelle (12, 24) zum Trennen des Arbeitspegels des Referenzsignals (U_{ref}) von dem Integrator (18, 20) ansteuern.

3. Vorrichtung nach Anspruch 2,
**dadurch gekennzeichnet,**
**dass** die Steuermittel (28) weiter eingerichtet sind, die schaltbare Referenzspannungsquelle (12, 24) jeweils nach einem vorbestimmten Zeitintervall (T_{c}) nach dem Trennen des Arbeitspegels des Referenzsignals (U_{ref}) von dem Integrator (18, 20) zum erneuten Anlegen des Arbeitspegels des Referenzsignals (U_{ref}) an den Integrator (18, 20) anzusteuern.

4. Vorrichtung nach Anspruch 3,
**dadurch gekennzeichnet,**
**dass** die Gesamtdauer zwischen zwei aufeinander folgenden Polaritätsechseln des Zwischensignals (U_{Z}) als Basis für das Maß für das Eingangssignal (U_{E}) dient.

5. Vorrichtung nach Anspruch 2,
**dadurch gekennzeichnet,**
**dass** die Steuermittel (28) weiter eingerichtet sind, die schaltbare Referenzspannungsquelle (12, 24) jeweils nach einem festen Zeitintervall (T_{T}) nach einem vorangegangenen Anlegen des Arbeitspegels des Referenzsignals (U_{ref}) an den Integrator (18, 20) zum erneuten Anlegen des Arbeitspegels des Referenzsignals (U_{ref}) an den Integrator (18, 20) anzusteuern.

6. Vorrichtung nach einem der vorangehenden Ansprüche
**dadurch gekennzeichnet,**
**dass** Additionsmittel zur Aufsummierung einer geraden Anzahl von Messintervalldauern und Ausgabemittel zur Ausgabe eines Ausgabewertes auf Basis des aufsummierten Wertes als Maß für das Eingangssignal vorgesehen sind.

7. Vorrichtung nach Anspruch 6,
**dadurch gekennzeichnet,**
**dass** die Additionsinittel eingerichtet sind, einer aktuellen Bestimmung des aufsummierten Wertes die einer vorangegangenen Bestimmung zugrunde liegende Folge von Messintervalldauern ohne eine vorgegebene Anzahl von Dauern ältester Messintervalle und mit zusätzliche derselben Anzahl Dauern jüngster, bei der vorangegangenen Bestimmung nicht berücksichtigter Messintervalle zugrunde zu legen.

8. Messverstärkungsverfahren zur Erfassung eines monopolaren Eingangssignals (U_{E}) und zur Erzeugung eines digitalen Ausgangswertes als Maß für das Eingangssignal (U_{E}), bei dem das Eingangssignal (U_{E}) mittels eines von einem Taktgeber mit einem Polaritätswechseltakt angesteuerten, schaltbaren Wechselrichters (10) in ein mit dem Polaritätswechseltakt bipolares Zwischensignal (U_{Z}) umgewandelt wird und der digitale Ausgangswert mittels eines A/D-wandlers in Abhängigkeit von dem Zwischensignal (U_{Z}) erzeugt wird, wobei
bei Betrieb das Zwischensignal (U_{Z}) dauerhaft und ein Arbeitspegel eines bipolaren Referenzsignals (U_{ref}) aus einer von dem Taktgeber angesteuerten, schaltbare Referenzspannungsquelle (12, 24) zeitweise zur repetitiven Integration an einen Integrator (18, 20) des A/D-Wandlers angelegt werden,
ein Integrator-Ausgangssignal von einem dem Integrator (18, 20) nachgeschalteten Komparator (26) mit einem Schwellenwert verglichen wird, wobei ein von dem Vergleichsergebnis abhängiges Komparator-Ausgangssignal als Steuersignal (S_{Z}) zu dem Wechselrichter (10) und der Referenzspannungsquelle (12, 24) rückgekoppelt wird, und
die Dauer von Messintervallen (Tₘ), während derer der Arbeitspegel des Referenzsignals (U_{ref}) an den Integrator (18, 20) angelegt ist, von Zeitmessmitteln als Basis eines Maßes für das Eingangssignal bestimmt werden,
**dadurch gekennzeichnet,**
**dass** die schaltbare Referenzspannungsquelle (12, 24) mit dem Wechselrichter (10) mittels des zur Vorgabe des Polaritätswechseltaktes rückgekoppelten Steuersignals (S_{Z}) synchronisiert wird, sodass das Referenzsignal (U_{ref}) mit dem Polaritätswechseltakt bipolar ist.

9. Verfahren nach Anspruch 8,
**dadurch gekennzeichnet,**
**dass** beim Vergleichen des Integrator-Ausgcmgssignals mit einem Schwellenwert der zeitpunkt von dessen Querung durch das Integrator-Ausgangssignal erfasst wird und der Polaritätswechsel des Zwischensignals (U_{Z}) sowie das Trennen des Arbeitspegels des Referenzsignals (U_{ref}) vom Integrator (18, 20) in Abhängigkeit von dem erfassten Zeitpunkt erfolgt.

10. Verfahren nach Anspruch 11,
**dadurch gekennzeichnet,**
**dass** der Arbeitspegel des Referenzsignals (U_{ref}) jeweils nach einem vorbestimmten Zeitintervall (T_{c}) nach dem Trennen des Arbeitspegels des Referenzsignals (U_{ref}) von dem Integrator (18, 20) erneut an den Integrator (18, 20) angelegt wird.

11. Verfahren nach Anspruch 10,
**dadurch gekennzeichnet,**
**das** die Gesamtdauer (T_{T}) zwischen zwei aufeinander folgenden Polaritätswechseln des Zwischensignals (U_{Z}) als Basis für das Maß für das Eingangssignal (U_{E}) verwendet wird.

12. Verfahren nach Anspruch 9,
**dadurch gekennzeichnet,**
**dass** der Arbeitspegel des Referenzsignals (U_{ref}) jeweils nach einem festen Zeitintervall (T_{T}) nach einem vorangehenden Anlegen des Arbeitspegels des Referenzsignals (U_{ref}) an den Integrator (18, 20) erneut an den Integrator (18, 20) angelegt wird.

13. Verfahren nach einem der Ansprüche 8 bis 12,
**dadurch gekenntzeichnet,**
**dass** eine gerade Anzahl aufeinander folgender Messintervalldauern aufsummiert werden und auf Basis des aufsummierten Wertes ein Maß für das Eingangssignal ausgegeben wird.

14. verfahren nach Anspruch 13,
**dadurch gekennzeichnet,**
**dass** einer aktuellen Bestimmung des aufsummierten Wertes die einer vorangegangenen Bestimmung zugrunde liegende Folge von Messintervalldauern ohne eine vorgegebene Anzahl von Dauern ältester Messintervalle und mit zusätzlich derselben Anzahl von Dauern jüngster, bei der vorangegangenen Bestimmung nicht berücksichtigter Messintervalle zugrunde gelegt wird.

## Claims

1. Measurement amplification device for detection of a monopolar input signal (U_{E}) and for generation of a digital output value as a measure for the input signal (U_{E}), comprising a switchable DC-AC converter (10), which is controlled by a clock pulse generator with a polarity change clock pulse and which converts the input signal (U_{E}) into an intermediate signal (U_{Z}) bipolar with the polarity change clock pulse, and an A/D converter which generates the digital output value in dependence on the intermediate signal, wherein the A/D converter comprises:
an integrator (18, 20) which repetitively integrates the intermediate signal (U_{Z}) constantly applied thereto during operation and an operating level, which is periodically applied thereto, of a bipolar reference signal (U_{ref}) from a switchable reference voltage source (12, 24) controlled by the clock pulse generator,
a comparator (26) which is connected downstream of the integrator (18, 20) and which compares an integrator output signal with a threshold value, wherein a comparator output signal dependent on the comparison result is fed back as control signal (S_{Z}) to the DC-AC converter and to the reference voltage source, and
time measuring means which as a basis of a measure for the input signal detect the durations of measuring intervals (Tₘ) during which the operating level of the reference signal (U_{ref}) is applied to the integrator (18, 20),
**characterised in that** the switchable reference voltage source (12, 24) is synchronised with the DC-AC converter (10) by means of the control signal (S_{Z}) which is fed back for presetting the polarity change clock pulse, so that the reference signal (U_{ref}) is bipolar with the polarity change clock pulse.

2. Device according to claim 1, **characterised in that** the comparator (26) is arranged for ascertaining every time instant of a crossing of the threshold value by the integrator output signal and control means (28) are providing for feedback of the comparator output signal, which control means control, in dependence on the ascertaining crossing time instant, the switchable DC-AC converter (10) for a polarity change of the intermediate signal (U_{Z}) and the switchable reference voltage signal (12, 24) for separation of the operating level of the reference signal (U_{ref}) from the integrator (18, 20).

3. Device according to claim 2, **characterised in that** the control means (28) are further arranged to control the switchable reference voltage source (12, 24), in each instance after a predetermined time interval (T_{c}) after separation of the operating voltage of the reference signal (U_{ref}) from the integrator (18, 20), for re-application of the operating level of the reference signal (U_{ref}) to the integrator (18, 20).

4. Device according to claim 3, **characterised in that** the total duration between two successive polarity changes of the intermediate signal (U_{Z}) serves as a basis for the measure for the input signal (U_{E}).

5. Device according to claim 2, **characterised in that** the control means (28) is further arranged to control the switchable reference voltage source (12, 24), in each instance after a fixed time interval (T_{T}) after a preceding application of the operating level of the reference signal (U_{ref}) to the integrator (18, 20), for re-application of the operating level of the reference signal (U_{ref}) to the integrator (18, 20).

6. Device according to any one of the preceding claims, **characterised in that** addition means for summation of an even number of measuring interval durations and output means for output of an output value on the basis of the summated value as a measure for the input signal are provided.

7. Device according to claim 6, **characterised in that** the addition means are arranged to base a current determination of the summated value on the succession, on which a preceding determination was based, of measuring interval durations without a preset number of durations of oldest measuring intervals and with in addition the same number of durations of the youngest measuring intervals not taken into consideration in the preceding determination.

8. Measurement amplification method for detection of a monopolar input signal (U_{E}) and for generation of a digital output value as a measure for the input signal (U_{E}), in which the input signal (U_{E}) is converted by means of a switchable DC-AC converter (10), which is controlled by a clock pulse generator with a polarity change clock pulse, into an intermediate signal (U_{Z}) bipolar with the polarity change clock pulse, and the digital output value is generated by means of an A/D converter in dependence on the intermediate signal (U_{Z}), wherein
during operation the intermediate signal (U_{Z}) is applied permanently, and an operating level of a bipolar reference signal (U_{ref}) from a switchable reference voltage source (12, 24) controlled by the clock pulse generator is applied periodically, to an integrator (18, 20) of the A/D converter for repetitive integration,
an integrator output signal from a comparator (26) connected downstream of the integrator (18, 20) is compared with a threshold value, wherein a comparator output signal dependent on the comparison result is fed back as control signal (S_{Z}) to the DC-AC converter (10) and to the reference voltage source (12, 24), and
the durations of measuring intervals (Tₘ) during which the operating level of the reference signal (U_{ref}) is applied to the integrator (18, 20) are determined by time measuring means as a basis of a measure for the input signal,
**characterised in that** the switchable reference voltage source (12, 24) is synchronised with the DC-AC converter (10) by means of the control signal (S_{Z}), which is fed back for presetting the polarity change clock pulse, so that the reference signal (U_{ref}) is bipolar with the polarity change clock pulse.

9. Method according to claim 8, **characterised in that** in the comparison of the integrator output signal with a threshold value the time instant of the crossing thereof by the integrator output signal is detected and the polarity change of the intermediate signal (U_{Z}) as well as the separation of the operating level of the reference signal (U_{ref}) from the integrator (18, 20) are carried out in dependence on the detected time instant.

10. Method according to claim 11, **characterised in that** the operating level of the reference signal (U_{ref}) is re-applied to the integrator (18, 20) in each instance after a predetermined time interval (T_{c}) after the separation of the operating level of the reference signal (U_{ref}) from the integrator (18, 20).

11. Method according to claim 10, **characterised in that** the total duration (T_{T}) between two successive polarity changes of the intermediate signal (U_{Z}) is used as a basis for the measure for the input signal (U_{E}).

12. Method according to claim 9, **characterised in that** the operating level of the reference signal (U_{ref}) is re-applied to the integrator (18, 20) in each instance after a fixed time interval (T_{T}) after a preceding application of the operating level of the reference signal (U_{ref}) to the integrator (18, 20).

13. Method according to any one of claims 8 to 12, **characterised in that** an even number of successive measuring interval durations is summated and a measure for the input signal is output on the basis of the summated value.

14. Method according to claim 13, **characterised in that** a current determination of the summated value is based on the succession, on which a preceding determination was based, of measuring interval durations without a preceding number of durations of oldest measuring intervals and with in addition the same number of durations of the youngest measuring intervals not taken into consideration in the preceding determination.

## Revendications

1. Dispositif d'amplification de mesure pour la saisie d'un signal d'entrée monopolaire (U_{E}) et pour la génération d'une valeur de sortie numérique en tant que mesure pour le signal d'entrée (U_{E}), comprenant un convertisseur commutable (10) commandé par un générateur de synchronisation avec une fréquence de changement de polarité, lequel convertit le signal d'entrée (U_{E}) en un signal intermédiaire (U_{Z}) bipolaire avec la fréquence de changement de polarité, et un encodeur analogique/numérique qui génère la valeur de sortie numérique en fonction du signal intermédiaire,
où l'encodeur analogique/numérique comporte:
un intégrateur (18, 20) qui intègre répétitivement le signal intermédiaire (U_{Z}) qui lui est durablement appliqué en service, ainsi qu'un niveau opérationnel d'un signal de référence bipolaire (U_{ref}) provenant d'une source de tension de référence commutable (12, 24) commandée par le générateur de synchronisation et qui lui est temporairement appliqué,
un comparateur (26) disposé en aval de l'intégrateur (18, 20), lequel compare un signal de sortie de l'intégrateur à une valeur seuil, un signal de sortie du comparateur dépendant du résultat de la comparaison étant rétrocouplé en tant que signal de commande (S_{Z}) au convertisseur et à la source de tension de référence, et
des moyens de mesure temporelle qui déterminent la durée d'intervalles de mesure (Tₘ), pendant lesquels le niveau opérationnel du signal de référence (U_{ref}) est appliqué à l'intégrateur (18, 20), en tant que base d'une mesure pour le signal d'entrée,
**caractérisé**
**en ce que** la source de tension de référence commutable (12, 24) est synchronisée avec le convertisseur (10) au moyen du signal de commande rétrocouplé pour la définition de la fréquence de changement de polarité, de telle manière que le signal de référence (U_{ref}) est bipolaire avec la fréquence de changement de polarité.

2. Dispositif selon la revendication 1,
**caractérisé**
**en ce que** le comparateur (26) est réalisé pour déterminer chaque moment d'un croisement de la valeur seuil par le signal de sortie de l'intégrateur, et en ce que des moyens de commande (28) sont prévus pour le rétrocouplage du signal de sortie du comparateur, lesquels commandent le convertisseur commutable (10) en fonction du point d'intersection déterminé pour un changement de polarité du signal intermédiaire (U_{Z}) et la source de tension de référence commutable (12, 24) pour la déconnexion du niveau opérationnel du signal de référence (U_{ref}) de l'intégrateur (18, 20).

3. Dispositif selon la revendication 2,
**caractérisé**
**en ce que** les moyens de commande (28) sont en outre réalisés pour commander la source de tension de référence commutable (12, 24) à réappliquer le niveau opérationnel du signal de référence (U_{ref}) à l'intégrateur (18, 20), après un intervalle temporel défini (T_{c}) suivant la déconnexion du niveau opérationnel du signal de référence (U_{ref}) de l'intégrateur (18, 20).

4. Dispositif selon la revendication 3,
**caractérisé**
**en ce que** la durée totale entre deux changements de polarité successifs du signal intermédiaire (U_{Z}) sert de base pour la mesure du signal d'entrée (U_{E}).

5. Dispositif selon la revendication 2,
**caractérisé**
**en ce que** les moyens de commande (28) sont en outre réalisés pour commander la source de tension de référence commutable (12, 24) à réappliquer le niveau opérationnel du signal de référence (U_{ref}) à l'intégrateur (18, 20), après un intervalle temporel fixe (T_{T}) suivant une application précédente du niveau opérationnel du signal de référence (U_{ref}) à l'intégrateur (18, 20).

6. Dispositif selon l'une des revendications précédentes,
**caractérisé**
**en ce que** sont prévus des moyens d'addition pour la totalisation d'un nombre pair de durées d'intervalles de mesure, ainsi que des moyens de sortie pour l'émission d'une valeur de sortie sur la base de la valeur d'addition en tant que mesure pour le signal d'entrée.

7. Dispositif selon la revendication 6,
**caractérisé**
**en ce que** les moyens d'addition sont réalisés pour prendre pour base d'une détermination actuelle de la valeur d'addition la suite de durées d'intervalles de mesure prise pour base d'une détermination précédente, sans un nombre défini de durées d'intervalles de mesure les plus anciens et avec en plus un nombre égal de durées d'intervalles de mesure les plus récents qui n'ont pas été pris en compte lors de la détermination précédente.

8. Procédé d'amplification de mesure pour la saisie d'un signal d'entrée monopolaire (U_{E}) et pour la génération d'une valeur de sortie numérique en tant que mesure pour le signal d'entrée (U_{E}), où, au moyen d'un convertisseur commutable (10) commandé par un générateur de synchronisation avec une fréquence de changement de polarité, le signal d'entrée (U_{E}) est converti en un signal intermédiaire (U_{Z}) bipolaire avec la fréquence de changement de polarité, et où la valeur de sortie numérique est générée au moyen d'un encodeur analogique/numérique en fonction du signal intermédiaire (U_{Z}), où
en service, le signal intermédiaire (U_{Z}) est durablement appliqué, et un niveau opérationnel d'un signal de référence bipolaire (U_{ref}) provenant d'une source de tension de référence commutable (12, 24) commandée par le générateur de synchronisation est temporairement appliqué pour intégration répétitive à un intégrateur (18, 20) de l'encodeur analogique/numérique,
un signal de sortie de l'intégrateur est comparé à une valeur seuil par un comparateur (26) disposé en aval de l'intégrateur (18, 20), et
la durée des intervalles de mesure (Tₘ), pendant lesquels le niveau opérationnel du signal de référence (U_{ref}) est appliqué à l'intégrateur (18, 20), est saisie par des moyens de mesure temporelle en tant que base d'une mesure pour le signal d'entrée,
**caractérisé**
**en ce que** la source de tension de référence commutable (12, 24) est synchronisée avec le convertisseur (10) au moyen du signal de commande (S_{Z}) rétrocouplé pour la définition de la fréquence de changement de polarité, de telle manière que le signal de référence (U_{ref}) est bipolaire avec la fréquence de changement de polarité.

9. Procédé selon la revendication 8,
**caractérisé**
**en ce que** lors de la comparaison du signal de sortie de l'intégrateur avec une valeur seuil, le moment de croisement de celle-ci par le signal de sortie de l'intégrateur est déterminé, et en ce que le changement de polarité du signal intermédiaire (U_{Z}) ainsi que la déconnexion du niveau opérationnel du signal de référence (U_{ref}) de l'intégrateur (18, 20) sont exécutés en fonction du moment déterminé.

10. Procédé selon la revendication 9,
**caractérisé**
**en ce que** le niveau opérationnel du signal de référence (U_{ref}) est réappliqué à l'intégrateur (18, 20), après un intervalle temporel défini (T_{c}) suivant la déconnexion du niveau opérationnel du signal de référence (U_{ref}) de l'intégrateur (18, 20).

11. Procédé selon la revendication 10,
**caractérisé**
**en ce que** la durée totale (T_{T}) entre deux changements de polarité successifs du signal intermédiaire (U_{Z}) est utilisée comme base pour la mesure du signal d'entrée (U_{E}).

12. Procédé selon la revendication 9,
**caractérisé**
**en ce que** le niveau opérationnel du signal de référence (U_{ref}) est réappliqué à l'intégrateur (18, 20), après un intervalle temporel fixe (T_{T}) suivant une application précédente du niveau opérationnel du signal de référence (U_{ref}) à l'intégrateur (18, 20).

13. Procédé selon l'une des revendications 8 à 12,
**caractérisé**
**en ce qu'**un nombre pair de durées d'intervalles de mesure successives est totalisé et en ce qu'une mesure pour le signal d'entrée est émise sur la base de la valeur d'addition.

14. Procédé selon la revendication 13,
**caractérisé**
**en ce qu'**est prise pour base d'une détermination actuelle de la valeur d'addition la suite de durées d'intervalles de mesure prise pour base d'une détermination précédente, sans un nombre défini de durées d'intervalles de mesure les plus anciens et avec en plus un nombre égal de durées d'intervalles de mesure les plus récents qui n'ont pas été pris en compte lors de la détermination précédente.
